Europäisches Patentamt

European Patent Office

Office européen des brevets

(19)

(11) **EP 1 103 007 B1**

(12) **EUROPÄISCHE PATENTSCHRIFT**

(45) Veröffentlichungstag und Bekanntmachung des Hinweises auf die Patenterteilung:
**17.09.2003 Patentblatt 2003/38**

(51) Int Cl.⁷: **G01V 3/08**, H03K 17/955

(21) Anmeldenummer: **99941498.0**

(22) Anmeldetag: **02.08.1999**

(86) Internationale Anmeldenummer:
**PCT/EP99/05559**

(87) Internationale Veröffentlichungsnummer:
**WO 00/008487 (17.02.2000 Gazette 2000/07)**

(54) **KAPAZITIVER NÄHERUNGSSCHALTER ZUR AUSWERTUNG KLEINER KAPAZITÄTSÄNDERUNGEN UND VERFAHREN HIERZU**

CAPACITIVE PROXIMITY SWITCH FOR EVALUATING MINOR CHANGES IN CAPACITANCE AND METHOD THEREFOR

COMMUTATEUR CAPACITIF DESTINE A L'EVALUATION DE CHANGEMENTS MINIMES DE LA CAPACITE ET PROCEDE ASSOCIE

(84) Benannte Vertragsstaaten:
**DE ES FR GB IT**

(30) Priorität: **03.08.1998 DE 19834891**
**15.09.1998 DE 19842189**
**24.09.1998 DE 19843749**

(43) Veröffentlichungstag der Anmeldung:
**30.05.2001 Patentblatt 2001/22**

(73) Patentinhaber: **PEPPERL + FUCHS GMBH**
**D-68307 Mannheim (DE)**

(72) Erfinder: **HILDEBRANDT, Andreas**
**D-67346 Speyer (DE)**

(74) Vertreter: **Mierswa, Klaus, Dipl.-Ing. et al**
**Friedrichstrasse 171**
**68199 Mannheim (DE)**

(56) Entgegenhaltungen:
EP-A- 0 564 164      DE-A- 19 701 899
FR-A- 2 371 676      US-A- 3 694 741
US-A- 5 442 347

EP 1 103 007 B1

**Beschreibung**

Die Erfindung betrifft einen kapazitiven Näherungsschalter zur Auswertung von Änderungen der Kapazität desselben, mit einer elektrischen Wechselstrombrücke aus vier Brückenzweigen, welche sich zwischen je zwei von vier Schaltungsknoten der Brücke erstrecken, wobei an zwei sich gegenüberliegende, nicht benachbarte Schaltungsknoten der Brücke Wechselspannung als Brückenspeisespannung angelegt ist, und jeweils die beiden Brückenzweige zwischen denbeiden Einspeise-Schaltungsknotenje eine der beiden Hälften der Brücke bilden, und an den übrigen beiden Schaltungsknoten über Diagonalspannungspfade eine auszuwertende Brückendiagonalspannung abnehmbar ist, zur Detektion einer sich nähernden oder entfernenden, elektrisch leitfähige Fläche, insbesondere Metallfläche, welche Teil eines veränderbaren Kondensators in einem der Brückenzweige der Brückenschaltung ist, wobei in den übrigen Brückenzweigen sich als weitere Blindwiderstände wenigstens ein Kondensator (kapazitive Brücke) oder wenigstens ein Kondensator und/oder wenigstens ein Widerstand (kapazitiv-ohmsche Brücke) befinden, wobei zur Gleichrichtungder beiden Brückenzweigspannungen getrennt nach der jeweiligen Brückenhälfte in den Diagonalspannungspfaden Gleichrichter angeordnet sind und die Brückendiagonalspannung erst nach der Gleichrichtungder beiden Brückenzweigspannungen als entsprechend der Änderung der Kapazität des veränderbaren Kondensators sich ändernde Gleichspannung ausgewertet wird, gemäß dem Oberbegriff des Anspruchs 1 sowie ein Verfahren gemäß dem Obebegriffdes Anspruchs 9.

Stand der Technik:

Die Auswertung von kleinen bis sehr kleinen Kapazitätsänderungen ist eine immer wiederkehrende Aufgabe in der Sensortechnik. Insbesondere bei kapazitiven Näherungsschaltern müssen sehr kleine Kapazitätsänderungen, nämlich in einem Größenbereich < 10 fF, sicher ausgewertet werden, wobei hier vor allem der Störfestigkeit sowie der Temperaturstabilität der betreffenden Schaltung eine zentrale Bedeutung zukommt.

Zur Auswertung kleiner Kapazitätsänderungen ist es bekannt, einen Oszillator einzusetzen, dessen Schwingungsamplitude sich in Abhängigkeit von der Sensorkapazität ändert. Die Größe der Schwingungsamplitude ist somit ein Maß für den Wert der Sensorkapazität. Eine derartige Schaltung besitzt den Nachteil, daß sie nicht prinzipbedingt temperaturstabil ist, weshalb bei einer derartigen Schaltung meist eine eventuell schwierig zu dimensionierende Temperaturkompensation notwendig ist. Des Weiteren ist die Oszillatorgüte gering, woraus eine breitbandige Schaltung mit schlechtem EMV-Verhalten resultiert. Des Weiteren ist es zur Auswertung kleiner Kapazitätsänderungen bekannt, einen Oszillator einzusetzen, dessen Frequenz sich in Abhängigkeit von der Sensorkapazität ändert. Damit ist ebenfalls der Nachteil verbunden, daß eine solche Schaltung nicht prinzipbedingt temperaturstabil ist, weshalb auch hier eine eventuell schwierig zu dimensionierende Temperaturkompensation nötig ist; auch eine solche Schaltung besitzt ein relativ schlechtes EMV-Verhalten.

Des Weiteren ist zur Auswertung kleiner Kapazitätsänderungen die sogenannte Switched-Capacitor-Technik bekannt, bei der ein kritisches Timing der Taktsignale nachteilig ist, weshalb ein äußerst stabiler Takt nötig ist, was je nach Verfahren eine aufwendige Schaltungstechnik erfordert.

Des Weiteren sind zur Auswertung kleiner Kapazitätsänderungen auch integrierende Schaltungen bekannt. Diese haben den Nachteil, daß meist eine erdfreie Kapazität notwendig ist. Darüberhinaus benötigen derartige Schaltungen in der Regel eine digitale Auswerteeinheit (meist Zähler) was einen großen Schaltungstechnischen Aufwand bedeutet. Derartig Konzepte kommen daher vorwiegendin der Mikrosystemtechnik zur Anwendung.

Des Weiteren ist es bekannt, daß die Auswertung kleiner Änderungen einer elektrischen Größe vorteilhaft mit Brückenschaltungen realisiert werden kann. Hierbei wird die zu messende Größe mit Referenzen verglichen, wobei diese durch gleichartige Elemente erzeugt werden. Somit können Temperatureinflüsse wirkungsvoll unterdrückt werden, sofern beide Brückenzweige der Brücke jederzeit die gleiche Temperatur haben. Änderungen der betreffenden Größe stellen sich dann als Änderungen der Brückendiagonalspannungdar. Die Verwendung von Blindwiderständen als Brückenelemente bedingt, daß die Brücke mit Wechselspannung betrieben werden muß. Somit stellt auch die Brückendiagonalspannung eine Wechselspannung dar. Die Auswertung der Brückendiagonalspannung stellt dabei nach dem Stand der Technik oft ein Problem dar, da

- die Amplitude der Wechselspannung aufgrund der geringen Kapazitätsänderung sehr klein ist, nämlich einige mV;
- die Frequenz der Wechselspannung, mit der die Brücke betrieben wird, und damit auch die Frequenz der Brückendiagonalspannung, im MHz-Bereich liegt, damit bei den gegebenen kleinen Kapazitätswerten die Zweigströme keine zu kleinen Werte annehmen;
- die Brückendiagonalspannung in vielen Fällen neben der Wechselspannungskomponente auch eine Gleichtaktkomponente mit erheblich größerer Amplitude als die Wechselkomponente enthält.

Derartige vorbekannte Lösungen sind zum Beispiel in den Druckschriften DE-C2-31 43 114, DE-A1-39 11 009, DE-A1-195 36 198, DE-A1-197 01 899, CH-558 534 sowie der EP-A1-0 723 166 enthalten.

Eine Schaltungsanordnung zum Eliminieren des Einflusses einer Phasenverschiebung zwischen den Spannungspotentialen der beiden Meßpunkte einer Wechselstrommeßbrücke mit komplexen Widerständen, wobei die Differenz der Spannungspotentiale das Meßsignal bildet Zwischen den Meßpunkten und den Eingangseinschlüssen einer Schaltung zur Differenzbildung in jedem Spannungspfad ist ein Gleichrichterventil angeordnet, wobei jedem derselben ein zwischen seinem Ausgang und einem mit der Wechselstrommeßbrücke gemeinsamen Bezugspotential liegender Speicher nachgeschaltet ist.

Kondensatoren als kapazitive Meßwertaufnehmer innerhalb einer Wechselstrommeßbrücke, entweder in einer Brückenschaltung mit vier Kapazitäten oder mit zwei Kapazitäten und zwei Widerständen,wobei jeweils eine Kapazität veränderlich ist, sind aus der Literaturstelle Heinz Schneider, Kondensatoren als Meßwertaufnehmer, Elektronik-Applikation Nr. 14, 9. Juli 1985, bekannt.

Durch die FR-A-2371676 ist ein Näherungsschalter mit einer Wechselstrombrücke bekannt geworden, welche mit einer Wechselspannung beaufschlagt wird. Die Brückenzweigspannungen werden gleichgerichtet und einzeln elektrischen Manipulationen unterworfen. Erst nach der Gleichrichtung der Brückenzweigspannungen werden diese als sich ändernde Gleichspannung als kapazitive Größe ausgewertet.

Technische Aufgabe:

Der Erfindung liegt die Aufgabe zugrunde, einen kapazitiven Näherungsschalter sowie ein Verfahren hierzu zu schaffen, der auf einer seiner Seiten gegen die Annäherung eines elektrisch leitfähigen Gegenstandes hochempfindlich ist und damit eine sichere Auswertung sehr kleiner Kapazitätsänderungen ermöglicht, wobei die Schaltung eine hohe Störfestigkeit sowie prinzipbedingteine hohe Temperaturstabilität aufweisen soll. Des Weiteren soll der Näherungsschalter mit vergleichsweise geringem Aufwand und somit preiswert realisierbar sein.

Offenbarung der Erfindungund deren Vorteile:

Der erfindungsgemäße Näherungsschalter besteht aus einer flächigen Mehrlagenplatine aus wenigstens zwei elektrisch isolierenden Schichten, zwischen denen eine elektrisch leitfähige Zwischenlage als erste Fläche eines Kondensators in einem der beiden Brückenzweige einer der Brückenhälften sich befindet, wobei auf einer der Schichten auf der der Zwischenlage gegenüberliegenden Seite eine flächige, elektrisch leitfähige Auflage als Sonde aufgebracht ist, welche die zweite Fläche dieses Kondensators bildet, wobei die elektrisch leitfähige Fläche relativ zu dieser Sonde beweglich ist und mit dieser den veränderbaren, flächigen Kondensator der Brückenschaltung bildet.

Der Näherungsschalter und das Verfahren weisen den Vorteil auf, dass eine sichere Auswertung sehr kleiner Kapazitätsänderungen möglich ist, wobei die Schaltung eine hohe Störfestigkeit und Temperaturstabilität aufweist und gegenüber eingekoppelten Störungen weitgehend unempfindlich ist. Ebenso ist der Näherungsschalter mit vergleichsweise geringem Aufwand realisierbar. Die Vorteile bestehen im Besonderen darin:

- Es muß keine Wechselspannung ausgewertet werden, sondern nur eine Gleichspannung.
- Zur Auswertung der Brückendiagonalspannung kann ein langsamer Operationsverstärker bzw. Komparator verwendet werden.
- Die Gleichrichtung der Brückenzweigspannungen kann z.B. mit Dioden erfolgen, wodurch sich eine sehr einfache Schaltung mit nur wenigen Bauelementen ergibt; vorteilhaft können sog. langsame Dioden eingesetzt werden um die Störfestigkeit zu unterdrücken. Die Gleichrichtung erfolgt erfindungsgemäß synchron mit gesteuerten Schaltern, falls eine besonders hohe Störunterdrückung gefordert wird.

Wichtig ist, daß die Gleichrichter der beiden Zweige gleiches Temperaturverhalten aufweisen, damit die gleichgerichtete Brückendiagonalspannung unabhängig von der Temperatur ist. Für eine gute Störunterdrückung ist es vorteilhaft, wenn der Schaltungsaufbau symmetrisch erfolgt, da eine Störung, die in gleicher Weise auf beide Brückenzweige einwirkt, keine Differenzspannung an den Gleichrichterausgängen verursacht.

Die Gleichrichtung der Brückenzweigspannungen kann entweder durch Dioden, vorzugsweise vier, oder gemäß der Erfindung durch gesteuerte Schalter, vorzugsweise vier, erfolgen, wobei bei der Verwendung von Schaltern diese paarweise gegenphasig angesteuert werden und synchron mit der Brückenspeisespannung von einem Schaltzustand in den anderen umgeschaltet werden.

Zusätzlich können eingekoppelte Störungen wirksam unterdrückt werden, indem vor die Gleichrichter der Brückenzweigspannungenje ein Tiefpaß-Filter, TP-Filter, geschaltet wird. Zu beachten ist, daß die Kapazität des TP-Filters auch durch parasitäre Kapazitäten der Gleichrichter gebildet werden kann, zum Beispiel Sperrschicht- bzw. Diffusionskapazität der PN-Übergänge von Gleichrichterdiodeoder der Eingangskapazität von elektronischen Schaltern, so daß auch auf die Kondensatoren verzichtet werden kann. Das EMV-Verhalten kann auch durch den Einsatz von relativ langsamen Gleichrichtdioden verbessert werden. In diesem Fall kann eventuell auf eine zusätzliche TP-Filterungverzichtet werden.

Gemäß der Erfindung werden anstelle von vier Dioden vier Schalter mit paarweise gegenphasiger Ansteuerung zur Gleichrichtung der Bruckenzweigspannungen eingesetzt. Hierdurch ist es möglich, auch Wechselspannungen gleichzurichten, deren Amplitude kleiner ist als die Schwellenspannung einer Gleichrichterdiode. Des weiteren werden Störspannungen besser unterdrückt, da nur solche Wechselspannungen vollständig gleichgerichtet werden, die mit dem Umschaltsignal der Schalter synchronisiert sind. Um die Wahrscheinlichkeit zu verringern, daß ein Störsignal die gleiche Frequenz aufweist wie das Umschaltsignal der Schalter, ist es empfehlenswert, die Frequenz der Brückenspeisespannung - und damit auch die des Umschaltsignals - laufend zu ändern.

Anstelle von vier einzelnengesteuerten Schaltern mit paarweise gegenphasiger Ansteuerung können auch zwei Umschalter eingesetzt werden.

Die sich nähernde oder entfernende Metallfläche, welche Teil eines Kondensators des kapazitiver Näherungsschalters ist, kann auch geerdet sein.

Verfahrensgemäß werden die beiden Brückenzweigspannungen getrennt nach der jeweiligen Brückenhälfte vier gesteuerte Schalter als Gleichrichter in den Diagonalspannungspfaden gleichgerichtet, wobei diese synchron mit der Brückenspeisespannung paarweise mittels Steuerspannungen geschlossen und geöffnet sowie gegenphasig angesteuert und synchron mit der Brückenspeisespannung von einem Schaltzustand in den anderen umgeschaltet werden,wobei die Frequenz der Brückenspeisespannung und damit auch die des Umschaltsignals der Schalter laufend geändert wird.

Zur Auswertung kleiner Änderungen einer Kapazität unter Verwendung eines kapazitiven Näherungsschalters werden somit die beiden Brükkenzweigspannungengetrennt nach der jeweiligen Brückenhälfte durch vier gesteuerte Schalter als Gleichrichter in den Diagonalspannungspfaden gleichgerichtet, wobei die Brückendiagonalspannung erst nach der Gleichrichtung der beiden Brückenzweigspannungen als sich entsprechend der Änderung der Kapazität ändernde Gleichspannung ausgewertet wird, und die Schalter synchron mit der Brückenspeisespannung paarweise gegenphasig angesteuert und synchron mit der Brückenspeisespannung von einem Schaltzustand in den anderen umgeschaltet werden. Die Frequenz der Brückenspeisespannung und damit auch die des Umschaltsignals kann laufend geändert werden.

Ein Abgleich der Schaltung bzw. des Näherungsschalters geschieht zweckmässigerweisedurchVeränderungder Kapazität eines der Kondensatoren in einem der Brückenzweige der Brücke. Dies kann z.B. mit Hilfe eines sog. Drehkondensators oder eines lasertrimmbaren Kondensators erfolgen. Es ist vorteilhaft, den Abgleich derart vorzunehmen, daß im Schaltpunkt des Näherungsschalters die Differenzspannung gleich Null ist, da es dann ausreicht, lediglich das Vorzeichen der Differenzspannung auszuwerten. Wird nur das Vorzeichen der Differenzspannung Ud ausgewertet, so ergibt sich ein Ausgangssignal mit zwei unterschiedlichen Zuständen, wobei der Umschaltpunkt, bei dem das Vorzeichen der DifferenzspannungUd von einem Zustand in den anderen wechselt, nur von dem Kapazitätswert des veränderlichen Kondensators abhängt, nicht jedoch von der Amplitude oder der Frequenz der Brückenspeisespannung ubr oder der Größe der Flußspannung Uf der Gleichrichterdioden.

Soll auf einen Abgleich mit Hilfe eines veränderbaren Kondensators verzichtet werden, kann der Nullpunkt der Differenzspannung auch dadurch eingestellt werden, daß zwei der Gleichrichtelemente mit ihrem einen Anschluß nicht am Referenzpotential, zum Beispiel Masse, angeschlossen werden, sondern jeweils an eine Referenzspannungsquelle,deren Wert so eingestellt wird, daß sich am Ausgang die gewünschte Differenzspannung Ud, nämlich meist Null, einstellt. Werden die beiden Referenzspannungen derart von der Brückenversorgungsspannung ubr abgeleitet, dass zwischen der jeweiligen Referenzspannung und der Brückenversorgungsspannungubr ein linearer Zusammenhang besteht, so wirkt sich eine Änderung der Brückenversorgungsspannung ubr nicht auf die Brückendiagonalspannung Ud - und damit auf den Abgleich - aus.

Kurzbeschreibung der Zeichnung,in der zeigen:

| Figur 1 | ein Prinzipschaltbild einer kapazitiven Brückenschaltung mit Auswertung |
| Figur2 | das Prinzipachaltbild der Figur 1 ergänzt um je einen Tiefpaß vor den Gleichrichtern |
| Figur 3 | ein Prinzipschaltbild, in welchem die Gleichrichterdioden durch Schalter ersetzt sind |
| Figur 4 a, b, c | das Ersetzen von zwei zusammengehörenden Gleichrichterdioden durch zwei zusammengehörende gleichrichtende Schalter bzw. das Ersetzen von zwei zusammengehörenden Schaltern durch jeweils einen Umschalter |
| Figur 5 | ein Prinzipschaltbild zum Einstellen des Nullpunktes der Brückendiagonalspannungmittels zweier Referenz spannungsquellen |
| Figur 6 | der Einsatz von Dioden mit der Schwellenspannung Uf als Gleichrichtelemente in Figur 5 |

Figur 7    eine Möglichkeit zum Erzeugen der Referenzspannung durch Gleichrichtung der Brückenspeisespannung und zweier Spannungsteiler

Figur 8    die Schaltung der Figur 7 erweitert um N5, N6, R8, C10 und Uv zum Nachweis dafür, dass die gleichgerichtete Spannung Ugl von der FlußspannungUfder Gleichrichterdiodenunabhängigist

Figur 9    ein weiteres Prinzipschaltbild einer Brückenschaltung mit je einer Kapazität in der einen Brückenhälfte und je einem ohmschen Widerstand in der anderen Brückenhälfte und

Figur 10    einen prinzipiellen Aufbau eines kapazitiven Näherungsschalters mit der Bildung der Kapazitäten eines Brükkenzweiges durch verschiedene Lagen einer Mehrlagenplatine in Kombination mit ihrer Umgebung.

In den Figuren sind gleiche Elemente mit gleichen Bezugzeichen versehen. Zur Klarstellungwerden die folgenden Begriffe verwendet: "Brückenhälfte" bedeutet - in den Figuren zeichnerisch - die linke bzw. rechte Seite bzw. Hälfte der Brücke, mit "Brückenzweig" ist der Schaltungsteil zwischen zwei Schaltungsknoten bezeichnet, so dass eine Brücke zwei "Hälften" und vier "Zweige" bzw. "Brückenzweige" besitzt.

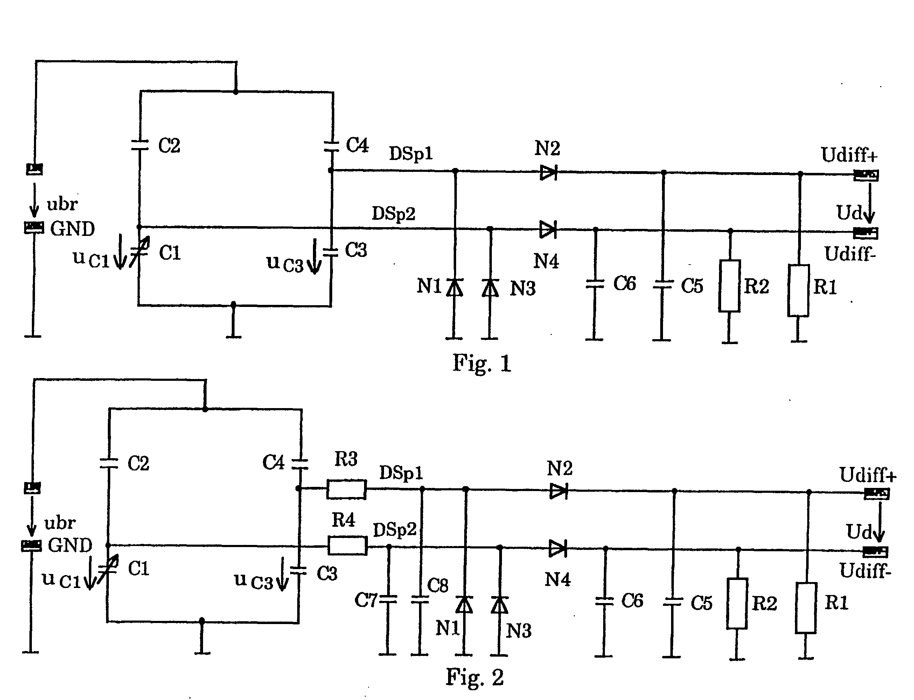

Die Figur 1 zeigt ein Prinzipschaltbild einer kapazitiven elektrischen Brückenschaltung, wie sie zum Aufbau eines kapazitiven Näherungsschalters verwendet werden kann, bestehend aus einer Brücke mit je einer Kapazität C1, C2, C3 undC4 injedem Brückenzweig; die Kapazität C1 ist veränderbar. Die Brücke wird gespeist durch die Brückenspeisespannung ubr, welche eine Wechselspannung ist; das Bezugspotential ist Masse GND.

Die beiden Brückenzweigspannungen uc1 und uc3 aus den beiden Brückenhälften werden getrennt nach dem jeweiligen Brückenzweig mittels Dioden N2, N1 bzw. N4, N3 in den Diagonalspannungspfaden DSp1 und DSp2 gleichgerichtet und mittels Kondensatoren C5, C6 sowie Widerständen R1 und R2 jeweils gegen Masse geglättet, wonach die Brückendiagonalspannung Ud als sich entsprechend der Änderung der Kapazität C1 ändernde Gleichspannung ausgewertet wird. Somit wird die Brückendiagonalspannung der Diagonalspannungspfade DSp1 undDSp2 erst nach Gleichrichtung der beiden Brückenzweigspannungen uc1 und uc3 als Differenzspannung Ud gewonnen, d. i. nach Figur 1 als gleichgerichtete Spannung Ud aus $u_{diff+} - u_{diff-}$.

Figur 2 zeigt das Prinzipschaltbildder Figur 1 ergänzt um je ein Tiefpaßfilter in jedem Brückenzweig vor den GleichrichternN2, N1, N4, N3 zur Unterdrückung von eingekoppelten Störungen, gebildet durch die in den Diagonalspannungspfaden DSp1 undDSp2 angeordneten Widerstände R3 undR4 zum Auskoppeln der beiden Brückenzweigspannungen uc1 und uc3 sowie die Kondensatoren C7, C8. Die Kapazitäten C7 und C8 der Tiefpaß-Filter R3-C8 sowie R4-C7 können auch durch die parasitären Kapazitäten der Elemente der Gleichrichter N1,N2,N3,N4, gebildet werden.

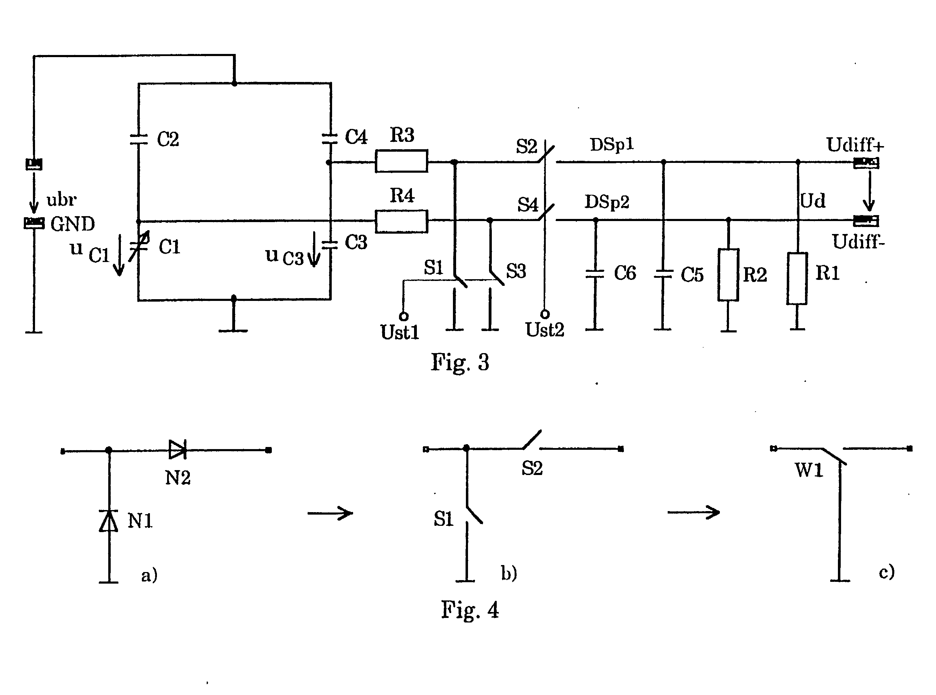

Figur 3 zeigt ein Prinzipschaltbild einer erfindungsgemäßen Schaltung, in welchem die Gleichrichterdioden durch elektronische Schalter S2, S1 bzw. S4, S3 ersetzt sind. Die beiden Schalter S2, S4 in den jeweiligen Auskopplungsleitungen der Brückenzweige werden durch die Steuerspannung Ust2, die beiden gegen Masse gelegten Schalter S1, S3 durch die Steuerspannung Ust1 angesprochen und geschlossen sowie geöffnet. Die Schalter werden paarweise gegenphasig angesteuert. Auch bei der Verwendung von Schaltern und Tiefpässen können die Kapazitäten der jeweiligenTiefpaß-Filter durch die parasitären Kapazitäten der Elemente der Schalter S1, S2; S3, S4 gebildetwerden.

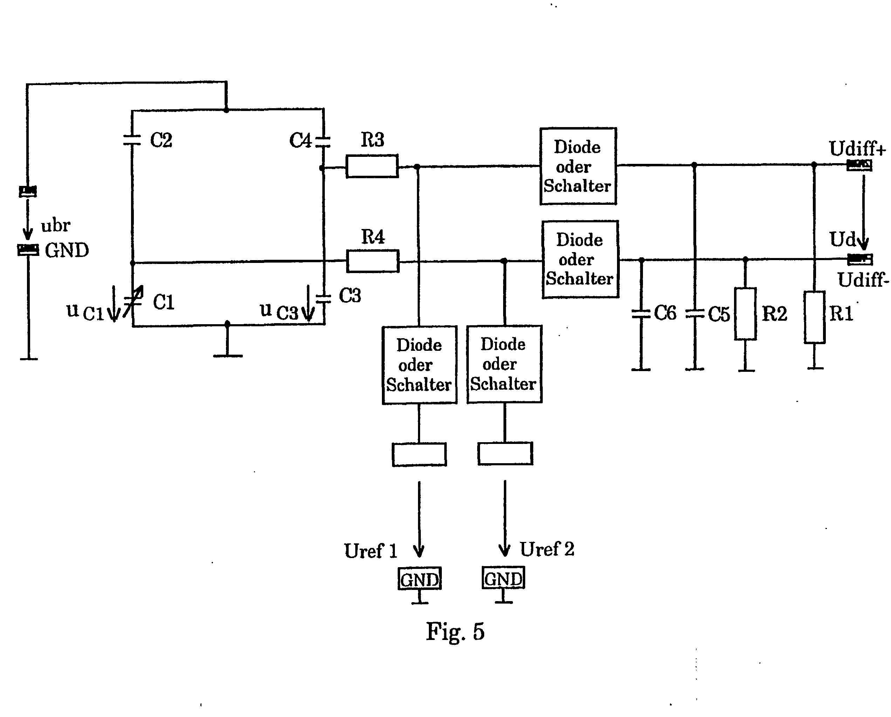

Figur 5 zeigt ein Prinzipschaltbild zum beispielsweise Einstellen des Nullpunktes der Brückendiagonalspannung Ud mittels zweier Referenzspannungsquellen Uref1 und Uref2. Zum Einstellen des Nullpunktes der Brückendiagonalspannung Ud sind zwei der Gleichrichtelemente - Diode oder Schalter - mit ihrem einen Anschluß nicht auf Masse, sondern jeweils an eine Referenzspannungsquelle Uref1, Uref2 angeschlossen, deren Bezugspotential Masse GND ist. Die Werte der Referenzspannungsquelle Uref1, Uref2 werden so eingestellt, daß sich am Ausgang die gewünschte Brückendiagmalspannung Ud einstellt.

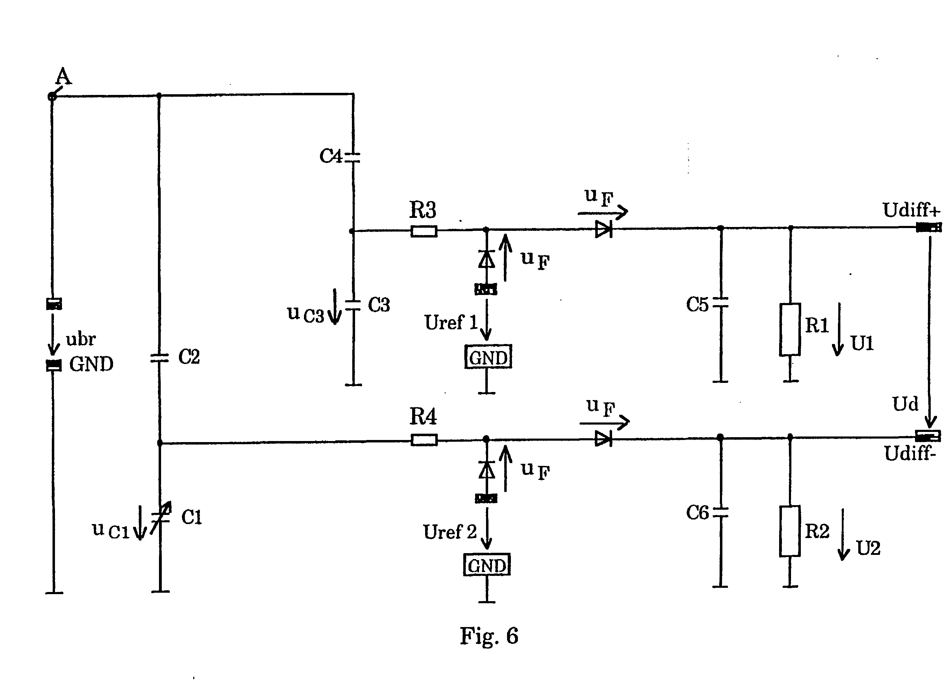

Figur 6 zeigt den Einsatz von Dioden als Gleichrichtelemente in Figur 5, wobei die Dioden die Schwellenspannung Uf aufweisen. Dann ergeben sich die folgenden Zusammenhänge:

$$Ud = U1 - U2$$

Die kapazitiven Spannungsteiler der beiden Brückenzweige schwächen das Signal ubr um den Faktor k bzw. k' ab. Sind die Kathoden zweier Gleichrichterdiodeam Referenzpotential, Masse, angeschlossen, d.h. wenn Uref 1 = Uref 2 = 0 ist, erhält man nach dem Gleichrichten die Spannungen

$$U1 = k\ ubr - 2Uf \qquad bzw. \qquad U2 = k'uBr - 2\ Uf$$

Dabei ist ubr der Spitze-Spitze-Wert der Brückenspeisespannung. Werden hingegen die Dioden kathodenseitig jeweils an eine von Null verschiedene Referenzspannung angeschlossen erhält man

$$U1 = k\ ubr - 2Uf + Uref1 \quad bzw. \quad U2 = k'\ ubr - 2Uf + Uref2$$

Man erhält dann für die DifferenzspannungUd:

$$Ud = U1 - U2 = k\ ubr - 2Uf + Uref1 - k'\ ubr + 2Uf - Uref2$$

$$= ubr\ (k - k') + Uref1 - Uref2$$

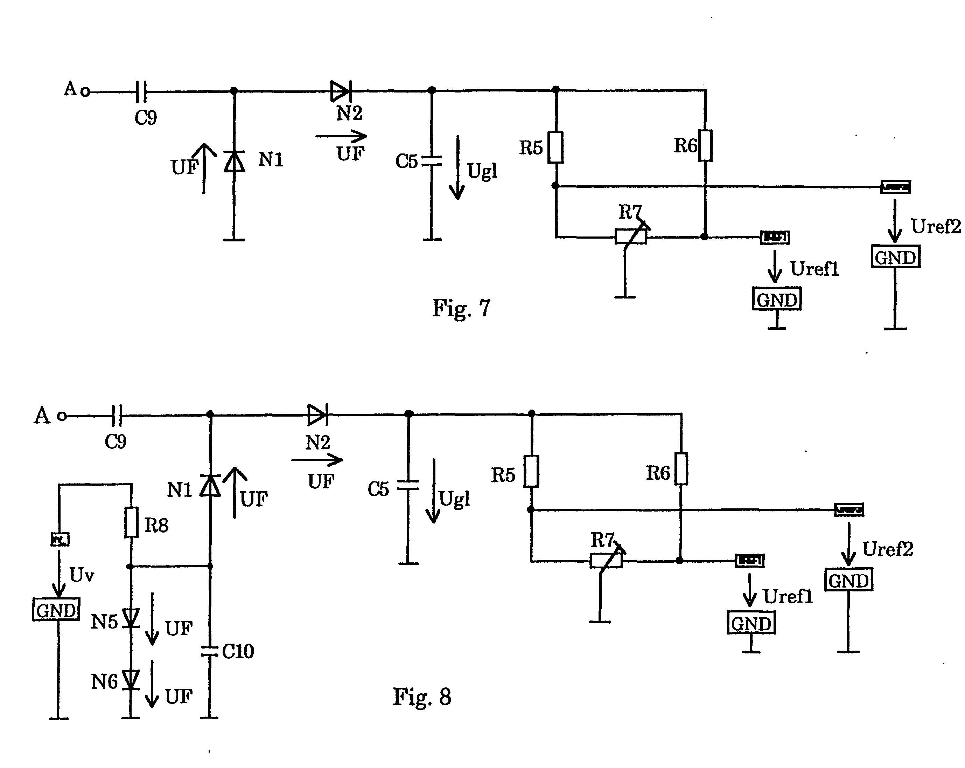

Daraus ist erkennbar, daß für k' = k und Uref2 = Uref1 die Spannung Ud zu Null wird und zwar unabhängigvon der Größe der Brückenspeisespannung ubr. Sind k und k' jedoch betragsmäßig verschieden, ergibt sich eine von Null verschiedene Differenzspannung Ud. Durch geeignete Wahl von Uref1 bzw. Uref2 kann die Differenzspannung Ud zwar zu Null gemacht werden. Ein Nachteil besteht jedoch noch darin, daß der beschriebene Nullabgleich von der Brückenspeisespannung ubr abhängt. In diesem Fall wäre es daher nötig, die Amplitude der Spannung ubr stabil zu halten. Dies ist insbesondere im Hinblick auf Temperaturänderungenin der Regel nur mit erheblichem Aufwand möglich.
Zur Herstellung des vorbeschriebenen Nullabgleichs unabhängig von der Brückenspeisespannung ubr zeigen deshalb die Figuren 7 und 8 Weiterbildungen von Schaltungen zum Erzeugen der Referenzspannung durch Gleichrichtung der Brückenspeisespannung und zweier Spannungsteiler. Hierzu werden die beiden Referenzspannungen Uref1 und Uref2 von der Brückenspeisespannung ubr am Schaltungspunkt A, Figuren 6 und 7, abgeleitet und zwar in der Form, daß zwischen der Amplitude der Brückenspeisespannung und der jeweiligen Referenzspannung ein linearer Zusammenhang besteht. Für die beiden Referenzspannungen gilt dann:

$$Uref1 = p\ ubr \quad bzw. \quad Uref2 = p'\ ubr$$

Für die DifferenzspannungUd ergibt sich dann:

$$Ud = ubr\ (k' - k) + p'\ ubr - p\ ubr = ubr\ (k' - k + p' - p)$$

Werden p' und p so gewählt, so daß gilt:

$$k' - k = p - p'$$

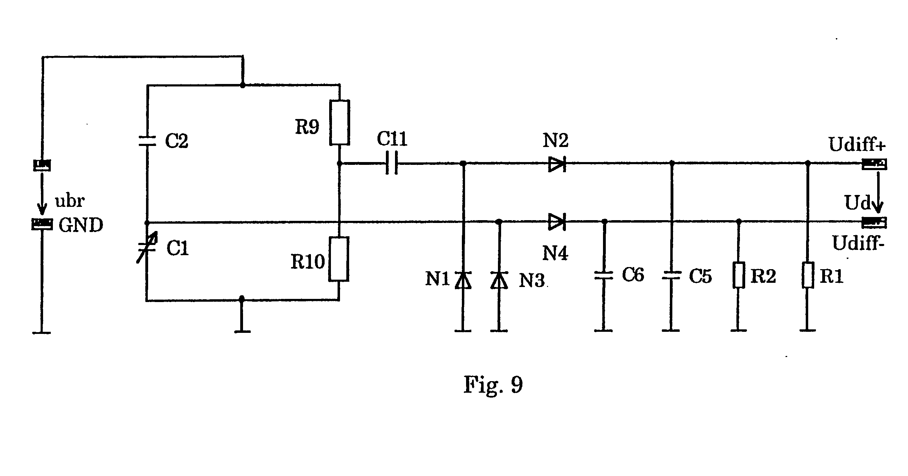

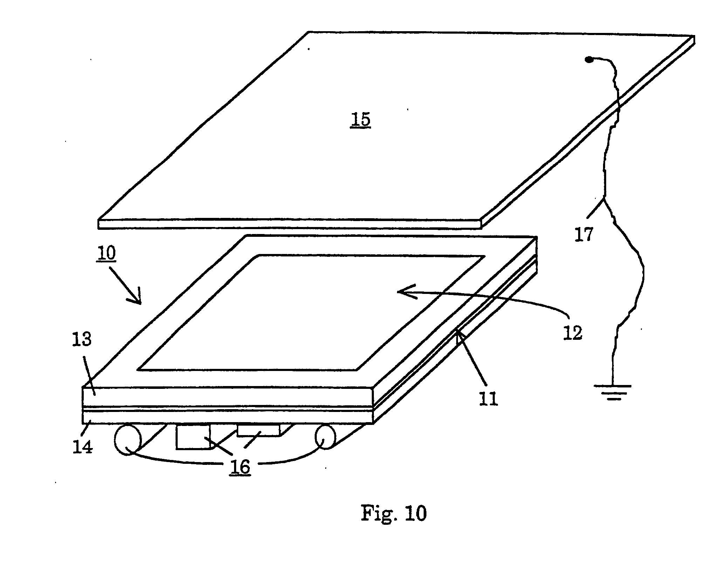

so wird die Differenzspannung Ud unabhängig von der Amplitude der Brückenspeisespannung ubr zu Null. Eine einfache Möglichkeit zum Erzeugen der Referenzspannung gemäß der vorstehenden Beziehung besteht darin, die Brückenspeisespannung ubr gleichzurichten und mit Hilfe je eines Spannungsteilers auf den gewünschten Wert einzustellen, was eben in Figur 7 gezeigt ist.
Figur 8 zeigt eine Schaltung, in der die gleichgerichtete Spannung Ugl auch von der Flußspannung Uf der Gleichrichterdioden unabhängig ist. Aufgrund der Temperaturabhängigkeit der Flußspannung Uf der Gleichrichterdioden ist die gleichgerichtete Brückenspeisespannung ebenfalls temperaturabhängig
Für die gleichgerichtete Spannung Ugl gilt: Ugl = ubr - 2Uf
Schließt man die Kathode der Gleichrichterdiodenicht am Referenzpotential, nämlich Masse, sondern an ein Potential der Höhe 2Uf an, so vereinfacht sich die Gleichungzu: Ugl = ubr
Die gleichgerichtete Spannung ist somit unabhängigvon Uf.
Grundsätzlich kann die erfindungsgemäße Schaltung auch mit einer Brücke aufgebaut werden, welche aus zwei Kapazitäten und zwei Widerständen in jedem Brückenzweig besteht, was prinzipiellin Figur 9 gezeigt ist. Dort ist eine kapazitive Brückenschaltung mit je einer Kapazität C1 und C2 sowie je einem ohmschen Widerstand R9, R10 in jedem Brückenzweig dargestellt. In der mit den Widerständen R9, R10 aufgebauten Brückenhälfte muß die entsprechende Brückenzweigspannung über einen Kondensator C11 ausgekoppelt werden, ansonsten entspricht die Brücke der vorbeschriebenen Figur 1.
Die beschriebene Schaltungsandornungist in besonderer Weise zum Aufbau des kapazitiven Näherungsschalters geeignet zur Detektion einer sich näherndenoder entfernenden elektrisch leitenden Fläche 15, zum Beispiel eine Metallfläche. Figur 10 zeigt einen prinzipiellenAufbau eines derartigen kapazitiven Näherungsschalters, welcher eine Hälfte der Brücke repräsentiert, mit der Bildungvon Kapazitäten eines Brückenzweiges durch verschiedene Lagen einer flächigen Mehrlagenplatine 10 in Kombination mit ihrer Umgebung.

Die Mehrlagenplatine 10 besteht aus wenigstens zwei elektrisch isolierenden Schichten 13, 14, zwischen denen eine elektrisch leitfähige Zwischenlage 11, zum Beispiel eine metallische Zwischenlage, als erste Fläche eines Kondensators sich befindet. Auf einer der beiden Schichten 13 bzw. 14, nämlich hier auf der oberen Schicht 13, ist eine flächige, ebenfalls elektrisch leitfähige Auflage als Sonde 12 aufgebracht, die die zweite Fläche des Kondensators bildet, wobei die Metallfläche 15 relativ zur Sonde 12 beweglich angeordnet ist und mit dieser einen zweiten flächigen, veränderbaren Kondensator mit zum Beispiel Luft als Dielektrikum bildet. Die Metallfläche 15 kann mittels einer Leitung 17 auch geerdet sein. Die Metallfläche 15 zusammen mit der Sonde 12 bilden die eine Kapazität der einen Brückenhälfte, die Sonde 12 und die metallische Schicht 11 bilden die zweite Kapazität derselben Brückenhälfte; dieser Aufbau repräsentiert die eine Hälfte der Brücke. Auf der der Sonde 12 entgegengesetzten Seite der Mehrlagenplatine 10, somit auf der unteren elektrisch isolierenden Schicht 14, sind weitere elektrische Bauelemente 16 aufgebracht.

Durch den in Figur 10 dargestellten Aufbau ergibt sich eine unterschiedlich große Änderung der Brückendiagonalspannung Du, je nachdem, von welcher Seite sich eine elektrisch leitende Fläche, zum Beispiel die metallische Fläche 15, an die Mehrlagenplatine 10 annähert. Somit kann eine Platinenseite als Sonde fungieren, nämlich hier die obere Seite mit der elektrisch leitfähigen Sonde 12, wohingegendie andere Platinenseite, hier die Schicht 14, gegenüber einer Annäherung einer leitenden Fläche, zum Beispiel die metallische Fläche 15, unempfindlichist, selbst dann, wenn diese geerdet ist.

Die Kondensatorfläche, gebildet durch die elektrisch leitfähige Zwischenlage 11, kann auch durch einen diskreten Kondensator ersetzt sein, welcher mit einem Anschluß an die Sonde 12 angeschlossen ist. In diesem Fall ergibt sich jedoch eine nahezu gleich große Änderung der Brückendiagonalspannung Ud, egal von welcher Seite sich eine elektrisch leitfähige Fläche dem Sensor 12 annähert oder entfernt. Eine Zwischenlage oder Abschirmung, wie zum Beispiel die elektrisch leitfähige Zwischenlage 11, sollte daher immer dann vorgesehen werden, wenn der Näherungsschalter in seinem Dickenaufbau dünner als sein Beeinflussungsbereich ist.

Es ist damit auf einfache und kostengünstige Weise möglich, kapazitive Näherungsschalter in flacher Bauform zu fertigen, die auch auf ein geerdetes Metallteilmontiert werdenkönnen.

Gewerbliche Anwendbarkeit:

Der Gegenstand der Erfindung ist insbesondere zum Einsatz als hochempfindlicher kapazitiver Näherungsschalter geeignet. Die Nützlichkeit des erfindungsgemäßenNäherungsschalters liegtinsbesondere darin, dass derselbe auf der einen Seite gegen die Annäherung eines metallischen Gegenstandes hochempfindlich, jedoch auf der gegenüberliegenden Seite gegen eine solche Annäherungpraktisch unempfindlichist.

**Patentansprüche**

1. Kapazitiver Näherungsschalter zur Auswertung von Änderungen der Kapazität desselben, mit einer elektrischen Wechselstrombrücke aus vier Brückenzweigen, welche sich zwischen je zwei von vier Schaltungsknoten der Brücke erstrecken, wobei an zwei sich gegenüberliegende, nicht benachbarte Schaltungsknoten der Brücke Wechselspannung als Brückenspeisespannung (ubr) angelegt ist, und jeweils die beiden Brückenzweige zwischen den beiden Einspeise-Schaltungsknoten je eine der beiden Hälften der Brücke bilden, und an den übrigen beiden Schaltungsknoten über Diagonalspannungspfade (DSp1, DSp2) eine auszuwertende Brückendiagonalspannung (Ud) abnehmbar ist, zur Detektion einer sich nähernden oder entfernenden, elektrisch leitfähige Fläche (15), insbesondere Metallfläche (15), welche Teil eines veränderbaren Kondensators (C1) in einem der Brückenzweige der Brückenschaltung ist, wobei in den übrigen Brückenzweigen sich als weitere Blindwiderstände wenigstens ein Kondensator (C1, C2, C3, C4) oder

   wenigstens ein Kondensator (C1, C2, C3, C4) undloder wenigstens ein Widerstand (R9, R10) befinden, wobei zur Gleichrichtung der beiden Brückenzweigspannungen (uc1, uc3) getrennt nach der jeweiligen Brückenhälfte in den Diagonalspannungspfaden (DSp1, DSp2) Gleichrichter (N1,N2,N3,N4,S1,S2,S3,S4) angeordnet sind und die Brückendiagonalspannung (Ud) erst nach der Gleichrichtung der beiden Brückenzweigspannungen (uc1, uc3) als entsprechend der Änderung der Kapazität des veränderbaren Kondensators (C1) sich ändernde Gleichspannung ausgewertet wird, **dadurch gekennzeichnet, dass**

   a) der Näherungsschalter aus einer flächigen Mehrlagenplatine (10) aus wenigstens zwei elektrisch isolierenden Schichten (13, 14) besteht, zwischen denen eine elektrisch leitfähige Zwischenlage (11) als erste Fläche eines Kondensators in einem der beiden Brückenzweige einer der Brückenhälften sich befindet

   b) auf einer der Schichten (13, 14) auf der der Zwischenlage (11) gegenüberliegenden Seite eine flächige, elektrisch leitfähige Auflage als Sonde (12) aufgebracht ist, welche die zweite Fläche dieses Kondensators bildet,

c) die elektrisch leitfähige Fläche (15) relativ zu dieser Sonde (12) beweglich ist und mit dieser den veränderbaren, flächigen Kondensator (C1) der Brückenschaltung bildet.

2. Näherungsschalter nach Anspruch 1, **dadurch gekennzeichnet,**
**dass** die Gleichrichterin den Diagonalspannungspfaden(DSp1, DSp2) entweder Dioden (N1, N2, N3, N4) oder gesteuerte Schalter (S1, S2, S3, S4), vorzugsweise jeweilsvier, sind.

3. Näherungsschalter nach Anspruch 2, **dadurch gekennzeichnet,**
**dass** die Schalter (S1, S2, S3, S4) synchron mit der Brückenspeisespannung (ubr) paarweise (S1,S3;S2,S4) mittels Steuerspannungen (Ust1, Ust2) geschlossen und geöffnet sowie gegenphasig angesteuert und synchron mit der Brückenspeisespannung (ubr) von einem Schaltzustand in den anderen umgeschaltet werden.

4. Näherungsschalter nach Anspruch 2 oder 3, **dadurch gekennzeichnet,**
**daß** zur Unterdrückung von eingekoppelten Störungen vor die Gleichrichter (N1, N2, N3, N4,S1, S2, S3, S4) der Brückenzweigspannungen (uc1, uc3) je ein Tiefpaß-Filter(R3, C8 und R4, C7) geschaltet ist.

5. Näherungsschalter nach Anspruch 4, **dadurch gekennzeichnet,**
**daß** die Kapazitäten der Tiefpaß-Filter (C8 bzw. C7) durch die parasitären Kapazitäten derGleichrichter (N1N2,N3,N4,S1,S2,S3,S4) gebildet sind.

6. Näherungsschalter nach Anspruch 2, **dadurch gekennzeichnet,**
**daß** als Schalter zur Gleichrichtung der Brückenzweigspannungen (uc1, uc3) zwei Umschalter (W1, W2) eingesetzt sind.

7. Näherungsschalter nach Anspruch 1, **dadurch gekennzeichnet,**
**daß** die durch die elektrisch leitfähige Zwischenlage (11) gebildete Kondensatorfläche durch einen diskreten Kondensator ersetzt ist, welcher mit einem Anschluß an die Sonde (12) angeschlossen ist.

8. Näherungsschalter nach Anspruch 2, **dadurch gekennzeichnet,**
**daß** die Dioden (N1,N2,N3,N4) zur Verbesserung der Störfestigkeit langsame Dioden sind.

9. Verfahren zur Auswertung von Kapazitätsänderungen der Kapazität eines kapazitiven Näherungsschalters mit einer elektrischen Wechselstrombrücke aus vier Brückenzweigen, welche sich zwischen je zwei von vier Schaltungsknoten der Brücke erstrecken, wobei in zwei sich gegenüberliegende, nicht benachbarte Schaltungsknoten der Brücke Wechselspannung als Brückenspeisespannung (ubr) eingespeist wird, und jeweils die beiden Brückenzweige zwischen den beiden Einspeise-Schaltungsknoten je eine der beiden Hälften der Brücke bilden, und an den übrigen beiden Schaltungsknoten über Diagonalspannungspfade (DSp1, DSp2) eine auszuwertende Brückendiagonalspannung (Ud) abgenommen wird, zur Detektion einer sich nähernden oder entfernenden, elektrisch leitfähige Fläche (15), insbesondere Metallfläche (15), welche Teil eines veränderbaren Kondensators (C1) in einem der Brückenzweige der Brückenschaltung ist, wobei in den übrigen Brückenzweigen sich als weitere Blindwiderstände wenigstens ein Kondensator (C1, C2, C3, C4)
oder
wenigstens ein Kondensator (C1, C2, C3, C4) und/oder wenigstens ein Widerstand (R9, R10) befinden, wobei die Brückendiagonalspannung (Ud) erst nach der Gleichrichtung der beiden Brückenzweigspannungen (uc1, uc3) als sich entsprechend der Änderung der Kapazität des veränderbaren Kondensators (C1) ändernde Gleichspannung ausgewertet wird,
**dadurch gekennzeichnet, dass**

a) die beiden Brückenzweigspannungen (uc1, uc3) getrennt nach der jeweiligen Brückenhälfte durch vier gesteuerte Schalter (S1,S2,S3,S4) als Gleichrichter in den Diagonalspannungspfaden (DSp1, DSp2) gleichgerichtet werden,
b) die Schalter synchron mit der Brückenspeisespannung (ubr) paarweise (S1,S3,S2,S4) mittels Steuerspannungen (Ust1, Ust2) geschlossen und geöffnet sowie gegenphasig angesteuert und synchron mit der Brückenspeisespannung (ubr) von einem Schaltzustand in den anderen umgeschaltet werden,
c) die Frequenz der Brückenspeisespannung (ubr) und damit auch die des Umschaltsignals der Schalter (S1,S3,S2,S4) laufend geändert wird.

10. Verfahren nach Anspruch 9, **dadurch gekennzeichnet,**

**dass** zum Abgleichen der Brücke und Einstellen des Nullpunktes der Brückendiagonalspannung (Ud) die Kapazität eines veränderbaren Kondensators (C2,C3,C4) in einem der Brückenzweige so verändert wird, dass im Schaltpunkt des Näherungsschalters die Brückendiagonalspannung (Ud) gleich Null ist und lediglich das Vorzeichen der Brückendiagonalspannung (Ud) ausgewertet wird.

**11.** Verfahren nach Anspruch 9, **dadurch gekennzeichnet,**
**dass** zum Einstellen des Nullpunktes der Brückendiagonalspannung (Ud) zwei der Schalter (S1,S2,S3,S4) mit ihrem einen Anschluß jeweils an eine Referenzspannungsquelle (Uref1,Uref2) angeschlossen werden, deren jeweiliger Wert so eingestellt wird, daß sich am Ausgang die gewünschte Brückendiagonalspannung (Ud) von Null Volt (0V) einstellt.

**12.** Verfahren nach Anspruch 11, **dadurch gekennzeichnet,**
**dass** zum Abgleichen der Brücke die beiden Referenzspannungen (Uref1, Uref2) aus der Brückenspeisespannung (ubr) abgeleitet und gleichgerichtet werden, so dass zwischen der Amplitude der Brückenspeisespannung (ubr) und der jeweiligen Referenzspannung (Uref1, Uref2) ein linearer Zusammenhang besteht.

**13.** Verfahren nach Anspruch 11 oder 12, **dadurch gekennzeichnet,**
**dass** die Referenzspannungen (Uref1, Uref2) mit Hilfe je eines Spannungsteilers auf die gewünschten Werte eingestellt werden.

## Claims

**1.** A capacitive approximation switch for evaluating changes in the capacitance thereof, having an electric alternating current bridge consisting of four bridge arms that each extend between two of four circuit nodes of the bridge, whereby alternating current is applied as the bridge supply voltage (ubr) at two circuit nodes of the bridge that are opposite from and not adjacent to each other, and each of the two bridge arms forms one of the two halves of the bridge between the two supply circuit nodes, and a bridge diagonal voltage (Ud) to be evaluated can be picked up via diagonal voltage paths (DSp1, DSp2) at the other two circuit nodes, in order to detect an electrically conductive surface (15) that is moving closer or moving away, especially a metal surface (15), that is part of a changeable capacitor (C1) in one of the bridge arms of the bridge circuit, whereby, in the other bridge arms, as additional reactive impedances, there is at least one capacitor (C1, C2, C3, C4) or else at least one capacitor (C1, C2, C3, C4) and/or at least one resistor (R9, R10), whereby in order to rectify the two bridge arm voltages (uc1, uc3), rectifiers (N1, N2, N3, N4, S1, S2, S3, S4) are arranged separately downstream from each bridge half in the diagonal voltage paths (DSp1, DSp2), and the bridge diagonal voltage (Ud) is only evaluated after the rectification of the two bridge arm voltages (uc1, uc3) as a changing direct current that corresponds to the change of the capacitance of the changeable capacitor (C1), **characterized in that**

(a) the approximation switch comprises a flat, multi-layer plate (10) consisting of at least two electrically insulating layers (13, 14), between which there is an electrically conductive intermediate layer (11) as a first surface of a capacitor in one of the two bridge arms of one of the bridge halves,
(b) on one of the layers (13, 14), on the side opposite from the intermediate layer (11), there is a flat, electrically conductive support as a probe (12) that forms the second surface of this capacitor,
(c) the electrically conductive surface (15) can be moved relative to this probe (12) and, together with the latter, forms the changeable flat capacitor (C1) of the bridge circuit.

**2.** The approximation switch according to Claim 1, **characterized in that** the rectifiers in the diagonal voltage paths (DSp1, DSp2) are either diodes (N1, N2, N3, N4) or controlled switches (S1, S2, S3, S4), preferably four of each.

**3.** The approximation switch according to Claim 2, **characterized in that** the switches (S1, S2, S3, S4) are opened and closed pairwise (S1, S3; S2, S4) synchronously with the bridge supply voltage (ubr) by means of control voltages (Ust1, Ust2) and they are controlled in phase opposition and are switched over from one switching state to the other synchronously by means of the bridge supply voltage (ubr).

**4.** The approximation switch according to Claim 2 or 3, **characterized in that**, in order to suppress the coupled-in interferences, a low-pass filter (R3, C8 and R4, C7) is installed upstream from the rectifiers (N1, N2, N3, N4, S1, S2, S3, S4) of the bridge arm voltages (uc1, uc3).

5. The approximation switch according to Claim 4, **characterized in that** the capacitances of the low-pass filters (C8 or C7) are formed by the parasitic capacitances of the rectifiers (N1, N2, N3, N4, S1, S2, S3, S4).

6. The approximation switch according to Claim 2, **characterized in that** two changeover switches (W1, W2) are used as switches for the rectification of the bridge arm voltages (uc1, uc3).

7. The approximation switch according to Claim 1, **characterized in that** the capacitor surface formed by the electrically conductive intermediate layer (11) is replaced by a discrete capacitor that is connected to the probe (12) via a connector.

8. The approximation switch according to Claim 2, **characterized in that** the diodes (N1, N2, N3, N4) are slow diodes in order to improve the interference immunity.

9. A process for evaluating capacitance changes in the capacitance of a capacitive approximation switch having an electric alternating current bridge consisting of four bridge arms that each extend between two of four circuit nodes of the bridge, whereby alternating current is supplied as the bridge supply voltage (ubr) at two circuit nodes of the bridge that are opposite from and not adjacent to each other, and each of the two bridge arms forms one of the two halves of the bridge between the two supply circuit nodes, and a bridge diagonal voltage (Ud) to be evaluated is picked up via diagonal voltage paths (DSp1, DSp2) at the other two circuit nodes, in order to detect an electrically conductive surface (15) that is moving closer or moving away, especially a metal surface (15), that is part of a changeable capacitor (C1) in one of the bridge arms of the bridge circuit, whereby, in the other bridge arms, as additional reactive impedances, there is at least one capacitor (C1, C2, C3, C4) or else at least one capacitor (C1, C2, C3, C4) and/or at least one resistor (R9, R10), whereby the bridge diagonal voltage (Ud) is only evaluated after the rectification of the two bridge arm voltages (uc1, uc3) as a changing direct current that corresponds to the change of the capacitance of the changeable capacitor (C1), **characterized in that**

   (a) the two bridge arm voltages (uc1, uc3) are rectified separately downstream from each bridge half by means of four controlled switches (S1, S2, S3, S4) as rectifiers in the diagonal voltage paths (DSp1, DSp2),
   (b) the switches (S1, S2, S3, S4) are opened and closed pairwise (S1, S3, S2, S4) synchronously with the bridge supply voltage (ubr) by means of control voltages (Ust1, Ust2) and they are controlled in phase opposition and are switched over from one switching state to the other synchronously by means of the bridge supply voltage (ubr),
   (c) the frequency of the bridge supply voltage (ubr) and thus also that of the switchover signal of the switches (S1, S2, S3, S4) is continuously changed.

10. The process according to Claim 9 **characterized in that**,
   in order to balance the bridge and to set the zero point of the bridge diagonal voltage (Ud), the capacitance of a changeable capacitor (C2, C3, C4) in one of the bridge arms is changed in such a way that, in the switching point of the approximation switch, the bridge diagonal voltage (Ud) is equal to zero and only the sign of the bridge diagonal voltage (Ud) is evaluated.

11. The process according to Claim 9, **characterized in that**,
   in order to set the zero point of the bridge diagonal voltage (Ud), the connection of two of the switches (S1, S2, S3, S4) are each connected to a reference voltage source (Uref1, Uref2) whose values are each set in such a way that the desired bridge diagonal voltage (Ud) of zero volt (0V) is set at the output.

12. The process according to Claim 11, **characterized in that**,
   in order to balance the bridge, the two reference voltages (Uref1, Uref2) are taken from the bridge supply voltage (ubr) and rectified, so that there is a linear relationship between the amplitude of the bridge supply voltage (ubr) and each reference voltage (Uref1, Uref2).

13. The process according to Claim 11 or 12, **characterized in that**
   the reference voltages (Uref1, Uref2) are set at the desired values by using a voltage divider.

**Revendications**

1. Commutateur capacitif destiné à l'évaluation de changements de la capacité de ce dernier, avec un pont à courant alternatif composé de quatre branches de pont qui s'étendent chacune entre deux des quatre noeuds de commutation du pont, une tension alternative étant appliquée en tant que tension d'alimentation du pont (ubr) à deux noeuds de commutation opposés et non voisins et les deux branches de pont entre les deux noeuds de commutation du courant d'alimentation formant chacune l'une des deux moitiés du pont, une tension diagonale de pont (Ud) à évaluer pouvant être prélevée aux deux autres noeuds de commutation via des circuits dérivés de tension diagonale (DSp1, DSp2) pour la détection d'une surface électroconductrice (15) qui s'approche ou s'éloigne, en particulier une surface métallique (15) qui fait partie d'un condensateur variable C1 dans l'une des branches de pont du circuit en pont, dans les autres branches du pont se trouvant comme autres réactances au moins un condensateur (C1, C2, C3, C4) ou au moins un condensateur (C1, C2, C3, C4) et/ou au moins une résistance (R9, R10), pour le redressement des deux tensions des branches de pont (uc1, uc3) des redresseurs (N1, N2, N3, N4, S1, S2, S3, S4) étant placés séparément pour chacune des moitiés de pont respectives dans les circuits dérivés de tension diagonale (DSp1, DSp2) et la tension diagonale de pont (ud) étant évaluée seulement après le redressement des deux tensions des branches de pont (uc1, uc3) en tant que tension continue variant conformément au changement de la capacité du condensateur variable (C1), **caractérisé en ce que**

a) le commutateur capacitif consiste en une platine multicouche plane (10) composée d'au moins deux couches (13, 14) électriquement isolantes, entre lesquelles se trouve une couche intermédiaire électroconductrice (11) en tant que première surface d'un condensateur dans l'une des deux branches de pont de l'une des moitiés de pont ;

b) sur l'une des couches (13, 14) sur le côté opposé à la couche intermédiaire (11), une surface plane électroconductrice est appliquée comme sonde (12) qui constitue la deuxième surface dudit condensateur ;

c) la surface électroconductrice (15) est mobile par rapport à ladite sonde (12) et constitue avec celle-ci le condensateur plan variable (C1) du circuit en pont.

2. Commutateur capacitif selon la revendication 1, **caractérisé en ce que**
les redresseurs dans les circuits dérivés de tension diagonale (DSp1, DSp2) sont ou bien des diodes (N1, N2, N3, N4) ou bien des commutateurs commandés (S1, S2, S3, S4), de préférence quatre à chaque fois.

3. Commutateur capacitif selon la revendication 2, **caractérisé en ce que**
les commutateurs (S1, S2, S3, S4) sont fermés et ouverts et commandés en opposition de phase de façon synchrone avec la tension d'alimentation de pont (ubr) par paire (S1, S3 ; S2, S4) au moyen des tensions de commande (Ust1, Ust2) et sont permutés de façon synchrone avec la tension d'alimentation de pont (ubr) d'un état de commutation à l'autre.

4. Commutateur capacitif selon l'une des revendications 2 ou 3, **caractérisé en ce que**
pour supprimer les perturbations induites, un filtre passe-bas (R3, C8 et R4, C7) est connecté en amont des redresseurs (N1, N2, N3, N4, S1, S2, S3, S4) de chacune des tensions des branches de pont (uc1, uc3).

5. Commutateur capacitif selon la revendication 4, **caractérisé en ce que**
les capacités des filtres passe-bas (C8 et C7) sont constituées par les capacités parasitaires des redresseurs (N1, N2, N3, N4, S1, S2, S3, S4).

6. Commutateur capacitif selon la revendication 2, **caractérisé en ce que**
deux commutateurs (W1, W2) sont utilisés en tant que commutateurs pour le redressement des tensions des branches de pont (uc1, uc3).

7. Commutateur capacitif selon la revendication 1, **caractérisé en ce que**
la surface de condensateur constituée par la couche intermédiaire électroconductrice (11) est remplacée par un condensateur discret qui est connecté à la sonde (12) par un raccordement.

8. Commutateur capacitif selon la revendication 2, **caractérisé en ce que**
les diodes (N1, N2, N3, N4) pour l'amélioration de la résistance aux perturbations sont des diodes lentes.

9. Procédé destiné à l'évaluation de changements de capacité de la capacité d'un commutateur capacitif avec un pont électrique de courant alternatif composé de quatre branches de pont qui s'étendent chacune entre deux des quatre noeuds de commutation du pont, une tension alternative étant appliquée en tant que tension d'alimentation du pont (ubr) à deux noeuds de commutation opposés et non voisins et les deux branches de pont entre les deux noeuds de commutation du courant d'alimentation formant chacune l'une des deux moitiés, une tension diagonale de pont (Ud) à évaluer étant prélevée aux deux autres noeuds de commutation via des circuits dérivés de tension diagonale (DSp1, DSp2) pour la détection d'une surface électroconductrice (15) qui s'approche ou s'éloigne, en particulier une surface métallique (15) qui fait partie d'un condensateur variable C1 dans l'une des branches de pont du circuit en pont, dans les autres branches du pont se trouvant comme autres réactances au moins un condensateur (C1, C2, C3, C4) ou au moins un condensateur (C1, C2, C3, C4) et/ou au moins une résistance (R9, R10), la tension diagonale de pont (Ud) n'étant évaluée qu'après redressement des deux tensions des branches de pont (uc1, uc3) en tant que tension continue variant conformément au changement de la capacité du condensateur variable (C1), **caractérisé en ce que**

a) les deux tensions des branches de pont (uc1, uc3) sont redressées séparément pour les moitiés de pont respectives par quatre commutateurs commandés (S1, S2, S3, S4) en tant que redresseurs dans les circuits dérivés de tension diagonale (DSp1, DSp2) ;
b) les commutateurs sont fermés et ouverts et commandés en opposition de phase de façon synchrone avec la tension d'alimentation de pont (ubr) par paire (S1, S3, S2, S4) au moyen des tensions de commande (Ust1, Ust2) et sont permutés de façon synchrone avec la tension d'alimentation de pont (ubr) d'un état de commutation à l'autre,
c) la fréquence de la tension d'alimentation de pont (ubr) et de ce fait aussi celle du signal de commutation des commutateurs (S1, S3, S2, S4) est changée en permanence.

**10.** Procédé selon la revendication 9, **caractérisé en ce que**
pour l'ajustage du pont et le réglage du zéro de la tension diagonale de pont (Ud), la capacité d'un condensateur variable (C2, C3, C4) dans l'une des branches de pont est changée de sorte qu'au point de commutation du commutateur capacititf la tension diagonale de pont (Ud) est égale à zéro et que seulement le signe de la tension diagonale de pont (Ud) est évalué.

**11.** Procédé selon la revendication 9, **caractérisé en ce que**
pour le réglage du zéro de la tension diagonale de pont (Ud), deux des commutateurs (S1, S2, S3, S4) sont connectés chacun avec leur raccordement à une source de tension de référence (Uref1, Uref2), dont les valeurs respectives sont réglées de sorte qu'à la sortie, s'établit la tension diagonale de pont (Ud) souhaitée de zéro Volt (0V).

**12.** Procédé selon la revendication 11, **caractérisé en ce que**
pour l'ajustage du pont, les deux tensions de référence (Uref1, Uref2) sont dérivées de la tension d'alimentation de pont (ubr) et redressées, de façon à ce qu'il existe une relation linéaire entre l'amplitude de la tension d'alimentation de pont (ubr) et la tension de référence respective (Uref1, Uref2).

**13.** Procédé selon l'une des revendications 11 ou 12, **caractérisé en ce que**
les tensions de référence (Uref1, Uref2) sont réglées chacune aux valeurs souhaitées à l'aide d'un diviseur de tension.

Fig. 1

Fig. 2

EP 1 103 007 B1

Fig. 3

a)

b)

c)

Fig. 4

EP 1 103 007 B1

Udiff+

Ud

Udiff-

R1

R2

C5

C6

Diode oder Schalter

Diode oder Schalter

Diode oder Schalter

Diode oder Schalter

Uref 2

GND

Uref 1

GND

Fig. 5

R3

R4

C3

C4

$u_{C3}$

C2

C1

$u_{C1}$

ubr GND

Fig. 6

Fig. 7

Fig. 8

Fig. 9

Fig. 10